# EUROPEAN PATENT APPLICATION

(11) **EP 4 760 996 A1**
(43) Date of publication of application: **17.06.2026**
(21) Application number: 25209590.6
(22) Date of filing: 17.10.2025
(51) Int. Cl.: H01R 12/70, H01R 12/72, H01R 13/6594, H05K 1/184, H01R 43/00, H01R 12/71, H01R 24/60

(54) **CONNECTOR AND CONNECTOR MOUNTING BOARD**

(30) Priority: 10.12.2024 JP 2024215352
(71) Applicant: Japan Aviation Electronics Industry, Ltd., Tokyo 150-0043 (JP)
(72) Inventor: ASHIBU, Kenta, Tokyo (JP)
(74) Representative: INNOV-GROUP

(57) **Abstract**

A technique for enabling a connector to be easily attached to and detached from a substrate is provided. A connector (100) according to the present disclosure can be attached to and detached from a substrate (300) including a plurality of pads (301), and can mate with an opponent connector. The connector 100 includes a plurality of contacts (121A), a shell (110) that holds the plurality of contacts (121A), and a coupling part that removably connects the shell (110) to the substrate (300). The shell (110) includes a shell body (111), and a claw (112) protruded from the shell body (111). The claw (112) includes a claw body (113), and a protrusion (114) protruded from the claw body (113). The claw (112) catches the substrate (300) and the coupling part couples the shell (110) to the substrate (300).

## Description

### BACKGROUND

The present disclosure relates to a connector and a connector mounting board.

Patent Literature 1 discloses a connector mounted on a substrate. A connector 900 shown in Fig. 22 is one example of this connector.

The connector 900 includes a shell 911 and a soldered part 912. The soldered part 912 is protruded from an outer surface of the shell 911. The soldered part 912 is inserted into a hole 801 of a circuit board 800 and soldered thereto. Thus, the connector 900 is fixed to the circuit board 800.

[Patent Literature 1] Japanese Unexamined Patent Application Publication No. 2012-182099

### SUMMARY

After the aforementioned connector is fixed to the substrate, in order to repair a connector, the connector may be replaced by another connector. In this case, it is not possible to easily attach a connector to a substrate and detach the connector from the substrate.

An object of the present disclosure is to provide a technique for capable of easily attaching a connector to a substrate and detaching the connector from the substrate.

A connector according to the present disclosure is a connector that is capable of being attached to and detached from a substrate including a plurality of pads and is capable of mating with an opponent connector, the connector including: a plurality of contacts; a shell configured to hold the plurality of contacts; and a coupling part configured to removably couple the shell to the substrate, in which the shell includes a shell body, and a claw protruded from the shell body, the claw includes a claw body and a protrusion that is protruded from the claw body, when the connector is attached to the substrate and is mounted on a mounting surface of the substrate as a result of the claw catching the substrate and the coupling part coupling the shell to the substrate, the contacts include respective contacting parts that are pushed against the plurality of respective pads, the claw body penetrates through the substrate, the protrusion extends along a rear surface that faces in a direction opposite to the direction in which the mounting surface faces, and when the connector is detached from the substrate, a distance between the contacting parts and the protrusion is smaller than a thickness of the substrate.

A connector mounting board according to the present disclosure is a connector mounting board including: a substrate including a plurality of pads; and a connector that is attached to the substrate, mounted on a mounting surface of the substrate, and is capable of mating with an opponent connector, in which the connector includes: a plurality of contacts; a shell configured to hold the plurality of contacts; and a coupling part configured to removably couple the shell to the substrate, the shell includes a shell body, and a claw protruded from the shell body, the claw includes a claw body and a protrusion that is protruded from the claw body, the claw catches the substrate and the coupling part couples the shell to the substrate, the contacts include respective contacting parts that are pushed against the plurality of respective pads, the claw body penetrates through the substrate, the protrusion extends along a rear surface that faces in a direction opposite to the direction in which the mounting surface faces, and when the connector is detached from the substrate, a distance between the contacting parts and the protrusion is smaller than a thickness of the substrate.

According to the present disclosure, it is possible to easily attach a connector to a substrate and detach the connector from the substrate.

The above and other objects, features and advantages of the present disclosure will become more fully understood from the detailed description given hereinbelow and the accompanying drawings.

### BRIEF DESCRIPTION OF DRAWINGS

Fig. 1 is an exploded perspective view of a substrate and a connector (first embodiment);
Fig. 2 is a perspective view showing a main part of the connector (first embodiment);
Fig. 3 is an exploded perspective view of a main part of the connector (first embodiment);
Fig. 4 is a diagram showing a method for using the connector (first embodiment);
Fig. 5 is a diagram showing the method for using the connector (first embodiment);
Fig. 6 is a diagram showing the method for using the connector (first embodiment);
Fig. 7 is a diagram showing the method for using the connector (first embodiment);
Fig. 8 is a perspective view showing the connector mounted on the substrate (first embodiment);
Fig. 9 is a perspective view showing the connector mounted on the substrate seen from another angle (first embodiment);
Fig. 10 is a bottom view showing the connector mounted on the substrate (first embodiment);
Fig. 11 is a perspective view showing the connector (second embodiment);
Fig. 12 is a cross-sectional view taken along the arrow XII-XII of Fig. 11 (second embodiment);
Fig. 13 is a diagram showing the method for using the connector (second embodiment);
Fig. 14 is a diagram showing the method for using the connector (second embodiment);
Fig. 15 is a diagram showing the method for using the connector (second embodiment);
Fig. 16 is a perspective view showing the connector mounted on the substrate (second embodiment);
Fig. 17 is a diagram showing the method for using the connector (second embodiment);
Fig. 18 is a diagram showing the method for using the connector (second embodiment);
Fig. 19 is a diagram showing the method for using the connector (second embodiment);
Fig. 20 is a side view showing the connector mounted on the substrate (second embodiment);
Fig. 21 is a cross-sectional view taken along the arrow XXI-XXI of Fig. 16 (second embodiment); and

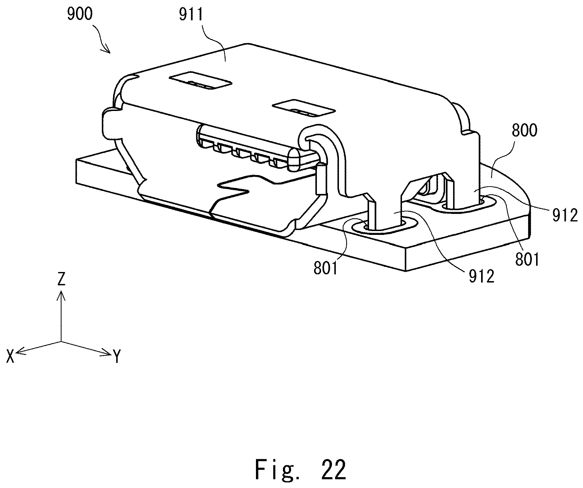

Fig. 22 is a diagram showing one example of a connector according to Patent Literature 1.

### DESCRIPTION OF EMBODIMENTS

Hereinafter, with reference to the drawings, specific embodiments to which the present disclosure is applied will be described in detail. However, the present disclosure is not limited to the following embodiments. Further, for the sake of clarification of the description, the following descriptions and drawings are simplified as appropriate.

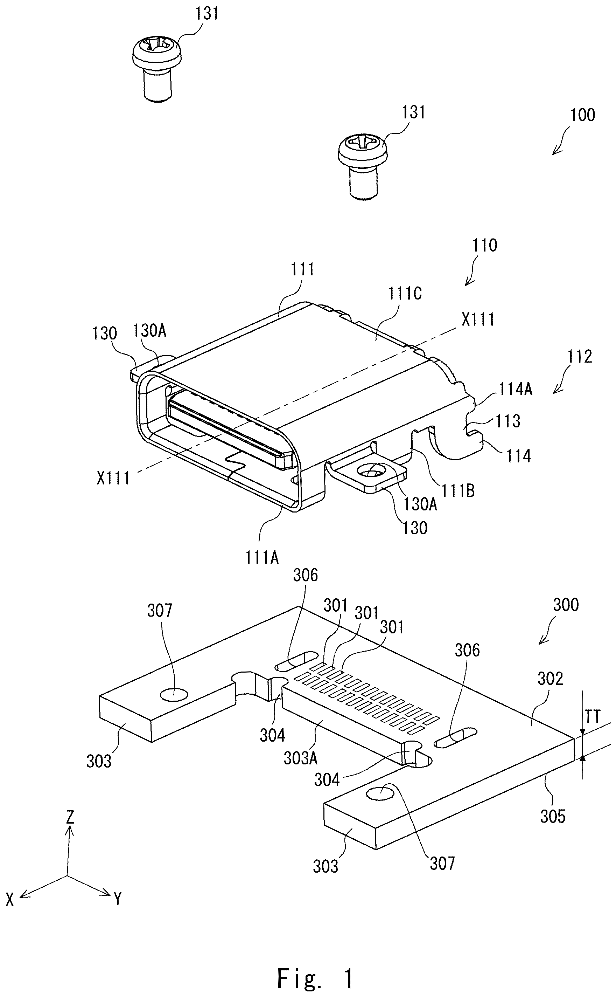

As a matter of course, the right-handed XYZ coordinates shown in Fig. 1 and other drawings are shown for convenience of describing the positional relationship of the components, and do not suggest any position when connectors 100 and 200 and the like that will be described below are actually used. Normally, an X-axis direction is a mating direction in which the connectors 100 and 200 that will be described below mate with opponent connectors that are not shown. Further, a Y-axis direction is a pitch direction, a Z-axis direction is a vertical direction, and an XY-plane is a horizontal plane, which is common among the drawings.

### <First Embodiment>

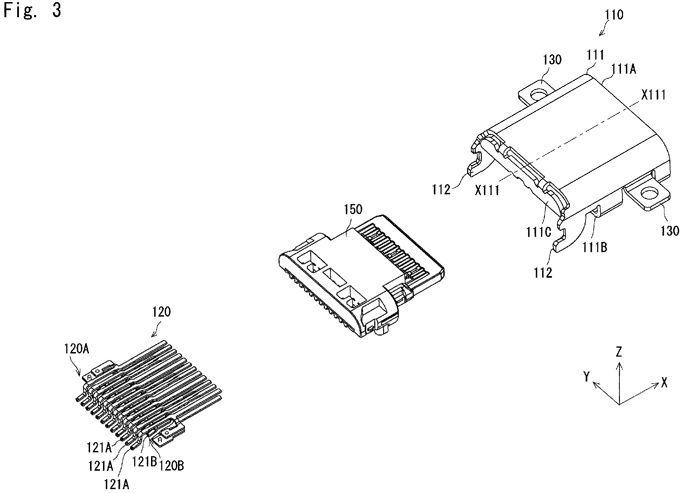

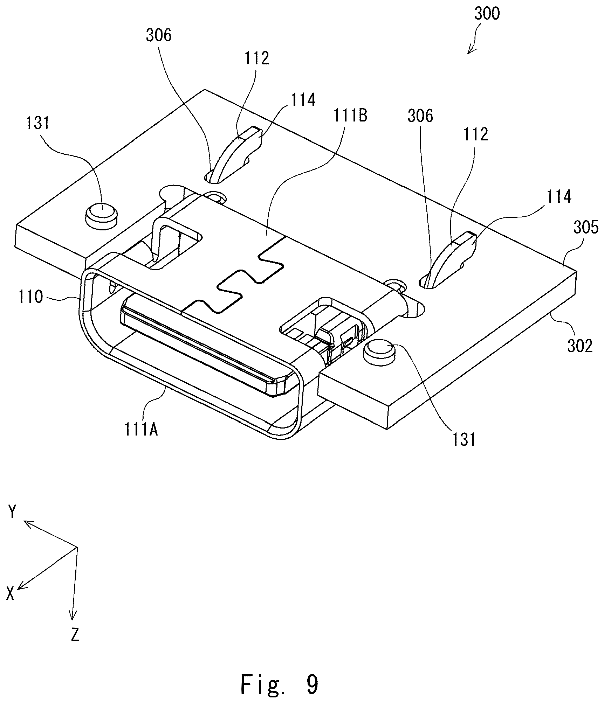

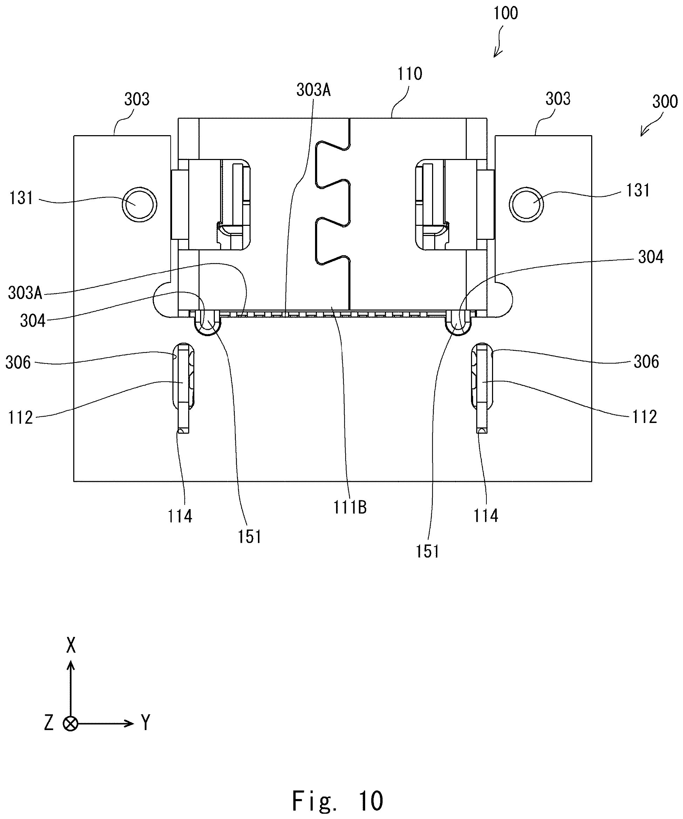

Hereinafter, with reference to Figs. 1 to 10, a first embodiment of the present disclosure will be described.

The connector 100 can be attached to a substrate 300. The connector 100 is mounted on a mounting surface 302 of the substrate 300 when the connector 100 is attached to the substrate 300. The substrate 300 is, for example, a printed board such as a rigid substrate. The substrate 300 includes a plurality of pads 301. The plurality of pads 301 are disposed on the mounting surface 302 so as to be aligned in a pitch direction. In the first embodiment, the plurality of pads 301 are aligned in two lines. The substrate 300 may include a concave surface 303A that is further recessed on an end surface 303 when the mounting surface 302 is seen from above. The concave surface 303A may have such a shape that it can contain the connector 100. Concave parts 304 that are further recessed may be disposed in the concave surface 303A. Holes 306 and female screws 307 are disposed on the mounting surface 302. The holes 306 extend from the mounting surface 302 to a rear surface 305, and penetrate through the substrate 300.

The connector 100 can mate with an opponent connector.

As shown in Figs. 1-3, the connector 100 includes a shell 110, a contact group 120, an insulator 150, and a screw-fastened part 130. The connector 100 may include one or a plurality of screw-fastened parts 130.

The shell 110 holds the contact group 120. The shell 110 may be made of, for example, a resin material or a metal material. Specifically, the shell 110 includes a shell body 111 and a claw 112. The shell 110 may include one or a plurality of claws 112.

The shell body 111 accommodates the contact group 120 and the insulator 150. The contact group 120 and the insulator 150 may be integrated with each other. The contact group 120 is insert-molded into the insulator 150 and integrated therewith. The shell body 111 is a substantially cylindrical body that surrounds the contact group 120 and the insulator 150. The shell body 111 includes a mating opening 111A, a substrate-side opening 111B, and a substrate-side end part 111C. The mating opening 111A contacts the opponent connector when the connector 100 mates with the opponent connector. The substrate-side opening 111B is opposed to the end surface 303 or the concave surface 303A when the connector 100 is attached to the substrate 300. When the connector 100 is attached to the substrate 300, the substrate-side end part 111C extends toward the substrate 300 from an upper part in the substrate-side opening 111B, and is opposed to the mounting surface 302.

The claws 112 may be disposed in the substrate-side end part 111C of the shell body 111. The claws 112 and the shell body 111 may be integrally molded. The claws 112 each include a claw body 113 and a protrusion 114. The claws 112 may be curved, and may extend, for example, in a substantially J shape. The claw body 113 is protruded from the shell body 111 toward the substrate 300 (the negative direction of the Z-axis in Fig. 1) in an outer diameter direction of the shell body 111. The protrusion 114 is protruded from the distal end of the claw body 113 in a direction in which an axis X111 of the shell body 111 extends. Each of the claws 112 may further include an extending part 114A. The extending part 114A extends from the substrate-side end part 111C or the root of the claw body 113 along the axis X111 of the shell body 111. The claw body 113, the protrusion 114, and the extending part 114A may extend, for example, in a substantially C shape or a substantially U shape.

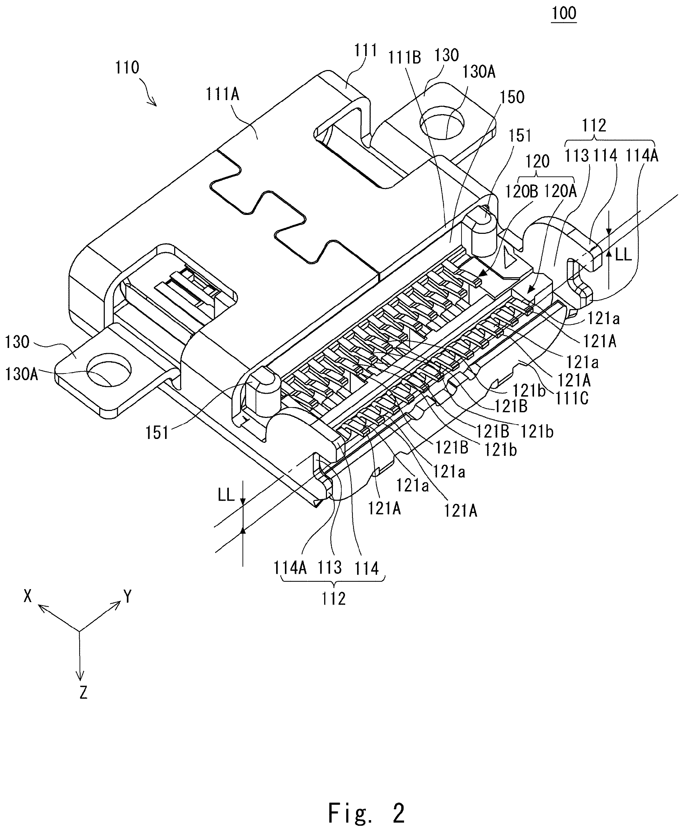

The contact group 120 includes rows of contacts 120A and 120B aligned in a pitch direction (in this example, Y-axis direction). The row of contacts 120A is disposed above the row of contacts 120B. The row of contacts 120A includes a plurality of contacts 121A. The row of contacts 120B includes a plurality of contacts 121B. Each of the contacts 121A and 121B may be elastically deformable in a vertical direction (in this example, Z-axis direction). Each of the contacts 121A and 121B may be a rod-like body made of a conductive material. The contacts 121A and 121B respectively include contacting parts 121a and 121b that are pushed against the respective pads 301 when the connector 100 is attached to the substrate 300. As shown in Fig. 2, when the connector 100 is detached from the substrate 300, the contacting parts 121a and the protrusions 114 are spaced apart from each other by a distance LL. The distance LL is smaller than a thickness TT of the substrate 300 shown in Fig. 1.

The insulator 150 is made of, for example, a resin material having insulating properties. The insulator 150 surrounds a part of the contact group 120. The insulator 150 insulates the contacts 121A and 121B. The contacts 121A and 121B of the contact group 120 extend out in a mating direction (in this example, X-axis direction) from the insulator 150. As shown in Fig. 2, the insulator 150 includes convex parts 151. The convex parts 151 are protruded from the substrate-side opening 111B of the shell body 111 in the mating direction. The convex parts 151 may be disposed between the shell body 111 and the claws 112.

As shown in Figs. 1-3, the screw-fastened parts 130 extend from the shell body 111. The screw-fastened parts 130 and the shell body 111 may be integrally molded. When the connector 100 is mounted on the mounting surface 302 of the substrate 300, the screw-fastened parts 130 may extend on and along the mounting surface 302. Specifically, the screw-fastened parts 130 may extend in the pitch direction. The screw-fastened parts 130 each include a penetrating hole 130A. The screw-fastened parts 130 can be fastened to the substrate 300 via male screws 131. By fastening the male screws 131 to the female screws 307 via the penetrating holes 130A of the screw-fastened part 130, the screw-fastened parts 130 can be fastened to the substrate 300. The screw-fastened parts 130 function as coupling parts that removably couple the shell 110 to the substrate 300.

### <Method>

Next, a method for attaching the connector 100 to the substrate 300 will be described.

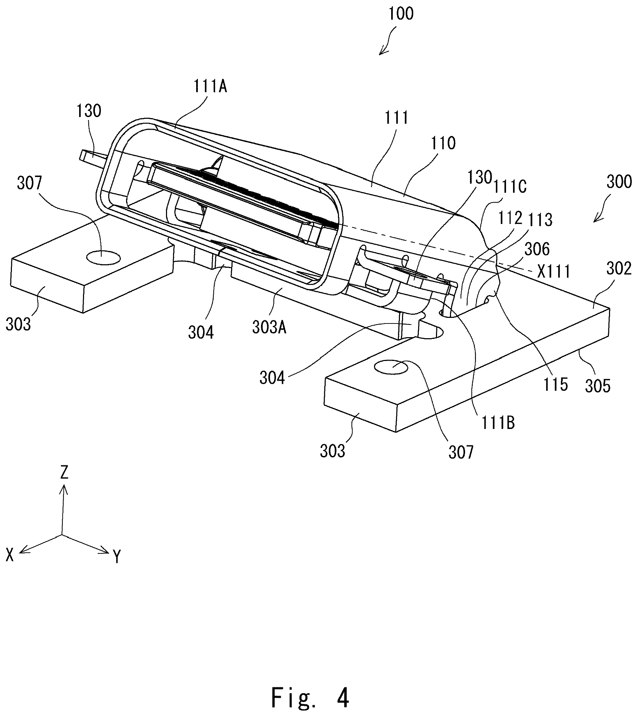

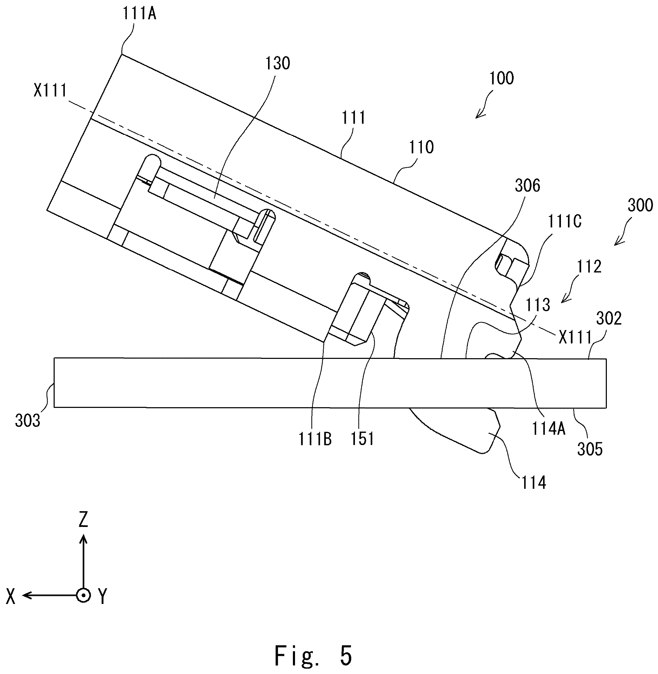

As shown in Figs. 4 and 5, the claws 112 of the shell 110 of the connector 100 are inserted into the holes 306 of the substrate 300 (Step ST11). Specifically, the position of the connector 100 is inclined in such a way that the axis X111 of the shell body 111 intersects with the mounting surface 302 of the substrate 300. The claws 112 are inserted into the holes 306 of the substrate 300. The claw bodies 113 are accommodated in the holes 306. The protrusions 114 are protruded toward the rear surface 305 from the holes 306. Further, the contacting parts 121a and 121b of the plurality of contacts 121A and 121B shown in Fig. 2 are pushed against the plurality of respective pads 301 shown in Fig. 1. The extending parts 114A abut the mounting surface 302, which can prevent the shell body 111 from moving toward the substrate 300 too much. It is therefore possible to prevent or reduce the plurality of contacts 121A and 121B from being pushed against the plurality of respective pads 301 and buckling.

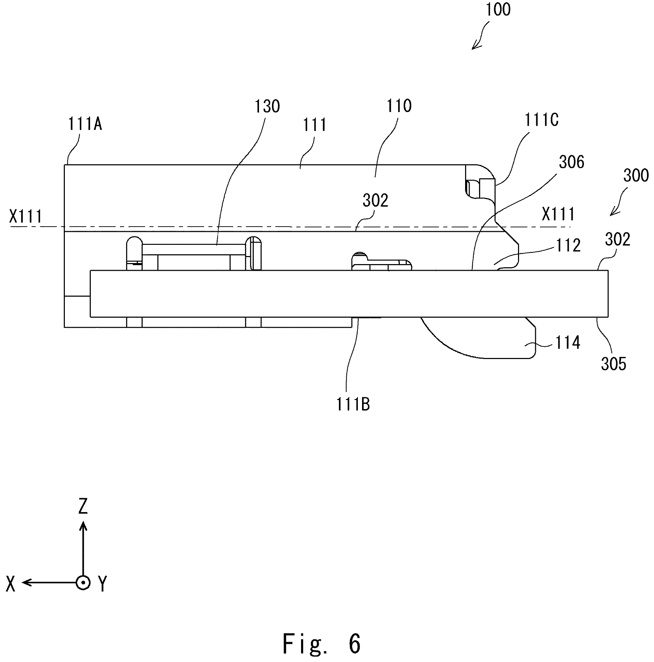

Next, as shown in Fig. 6, the position of the connector 100 is inclined in such a way that the axis X111 of the shell body 111 is along or parallel to the mounting surface 302 of the substrate 300 (Step ST12). The screw-fastened parts 130 and the female screws 307 of the mounting surface 302 shown in Fig. 4 are opposed to each other or contact each other. Thus, the claw body 113 shown in Fig. 5 passes through the hole 306 and penetrates through the substrate 300. Further, the protrusion 114 extends along the rear surface 305. That is, the claws 112 catch the substrate 300. Further, the plurality of contacts 121A and 121B shown in Fig. 2 are pushed against the plurality of respective pads 301 shown in Fig. 1, elastically deformed, and contact them.

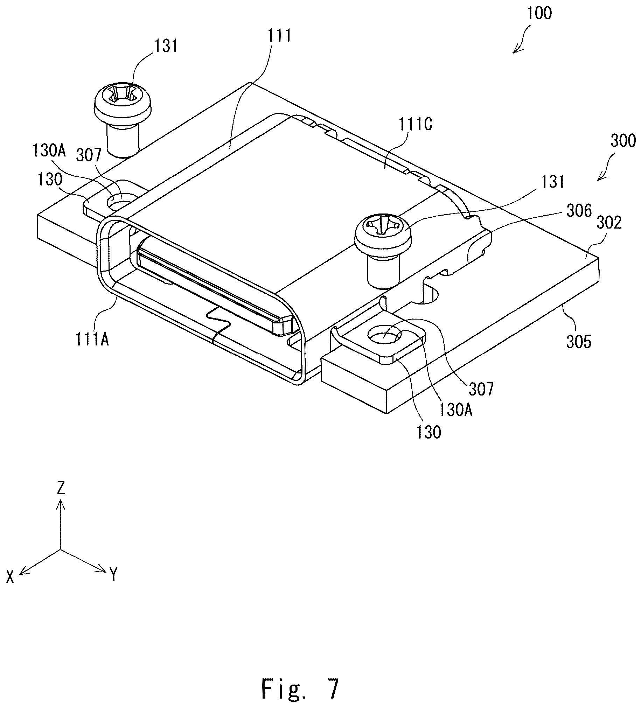

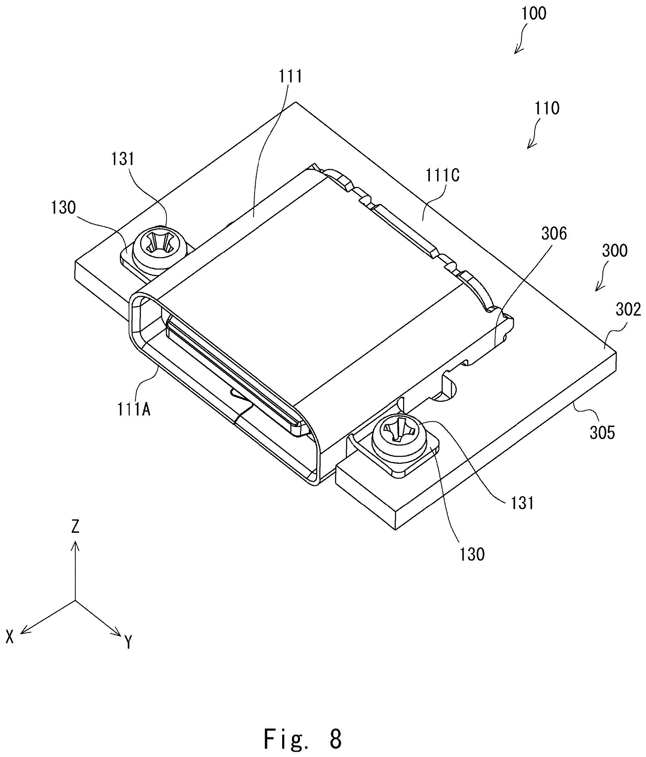

Last, as shown in Figs. 7 and 8, the male screws 131 are fastened to the female screws 307 (Step ST13). The male screws 131 may be fastened to the female screws 307 using a known driver. Thus, the screw-fastened parts 130 and the substrate 300 are fastened to each other via the male screws 131. That is, the screw-fastened parts 130 can couple the shell 110 to the substrate 300. Further, the plurality of contacts 121A and 121B shown in Fig. 2 keep contact with the plurality of respective pads 301 shown in Fig. 1.

From the above description, as shown in Figs. 8-10, the connector 100 is attached to the substrate 300. The plurality of contacts 121A and 121B shown in Fig. 2 contact the plurality of respective pads 301 shown in Fig. 1 and are electrically connected thereto. The substrate 300 to which the connector 100 is attached can be used as a connector mounting board.

Further, when the connector 100 is attached to the substrate 300, the convex parts 151 of the shell 110 mate with the concave parts 304 of the substrate 300. It is therefore possible to secure the accuracy of the position of the connector 100 in the pitch direction.

Regarding a method for detaching the connector 100 from the substrate 300, each step may be performed in an order that is reverse to the one in the aforementioned method for attaching the connector 100 to the substrate 300. That is, the male screws 131 are detached from the female screws 307, and the fastening of the screw-fastened parts 130 and the substrate 300 is released. Next, the position of the connector 100 is inclined in such a way that the axis X111 of the shell body 111 intersects with the mounting surface 302 of the substrate 300. Lastly, the claws 112 are removed from the holes 306. Thus, the connector 100 can be detached from the substrate 300.

The aforementioned method for attaching the connector 100 to the substrate 300 and the method for detaching the connector 100 from the substrate 300 do not require work that requires much skill or special tools such as soldering and desoldering. That is, these methods can be performed by using widely available tools or user's hands. It is therefore possible to easily attach the connector 100 to the substrate 300 and detach the connector 100 from the substrate 300.

### <Second Embodiment>

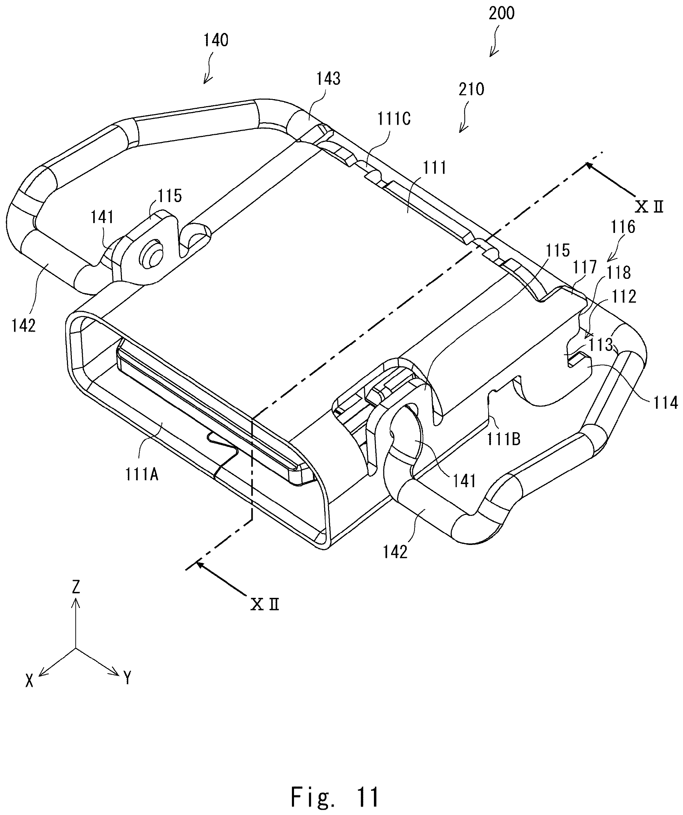

Next, with reference to Figs. 11 to 21, a second embodiment of the present disclosure will be described.

A connector 200 has a configuration the same as that of the connector 100 shown in Fig. 1 except that the connector 200 includes a lever 140, a base plate 170, and a shell 210. As shown in Figs. 11-13, the connector 200 includes a lever 140, a base plate 170, and a shell 210. The lever 140 and the base plate 170 function as coupling parts that removably couple the shell 210 to a substrate 300.

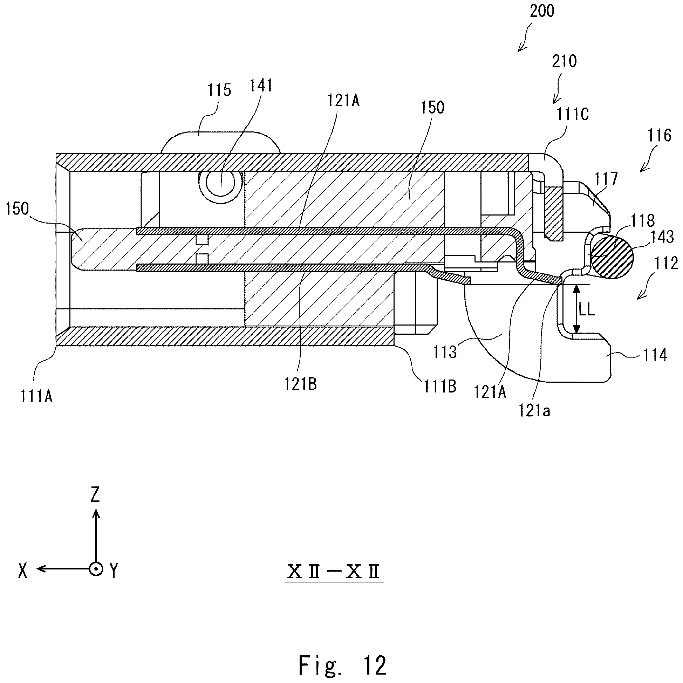

As shown in Figs. 11 and 12, the lever 140 is a rod-like body that extends in a substantially U shape. The lever 140 may be made of materials having flexibility or elastically deformable materials. The lever 140 includes a shaft 141, a cam part 142, and a gripping part 143. The shaft 141, the cam part 142, the gripping part 143, the cam part 142, and the shaft 141 link together in this order from one end to the other end of the lever 140. The lever 140 is rotatably held about the shaft 141 by a bearing 115 of the shell 210 that will be described later. The cam part 142 extends out, on a plane on which the lever 140 rotates (in this example, ZX-plane), in a direction in which it is separated away from the shaft 141. The gripping part 143 may extend, on the plane on which the lever 140 rotates, in a direction opposite to the direction in which the cam part 142 extends out. The gripping part 143 may have such a shape that can be gripped by the user.

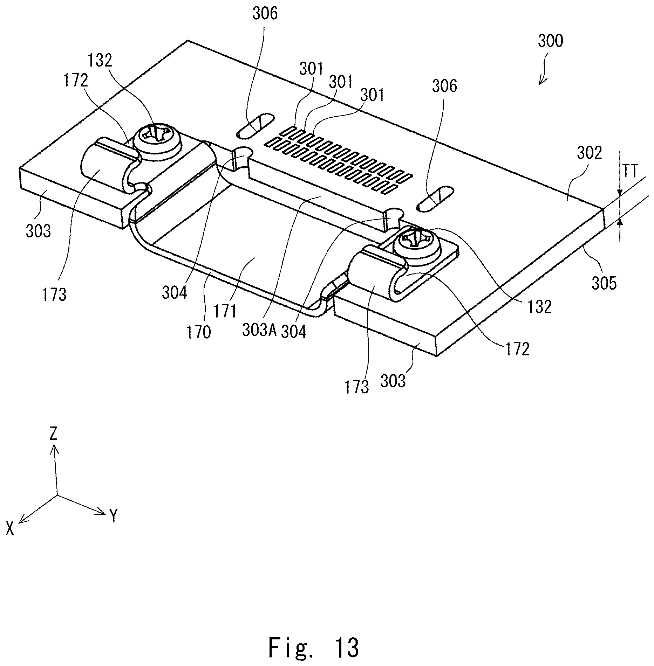

As shown in Fig. 13, the base plate 170 includes a shell holding part 171, fastening parts 172, and cam holding parts 173. The shell holding part 171 is a plate-like part that extends in a space surrounded by a concave surface 303A of the substrate 300. The shell holding part 171 may have such a shape that it can hold the shell 210. The fastening parts 172 are plate-like parts that extend in the pitch direction from both sides of the shell holding part 171 in the pitch direction. The fastening parts 172 are fastened to the substrate 300 via male screws 132. The cam holding parts 173 are plate-like parts that extend toward the end surface 303 from the fastening parts 172. The cam holding parts 173 may have such a shape that they can hold the cam part 142 in such a way that the cam part 142 can be rotated when the cam part 142 is pushed against the cam holding parts 173. Specifically, the cam holding parts 173 may curve in a substantially C shape on a plane (in this example, ZX-plane) perpendicular to the pitch direction.

As shown in Figs. 11 and 12, the shell 210 has a configuration the same as that of the shell 110 shown in Fig. 1 except that the shell 210 includes a bearing 115, a lever lock part 116, a wall 117, and a groove 118.

The bearing 115 holds the shaft 141 in such a way that the shaft 141 can be rotated. The bearing 115 may extend vertically upward (in this example, the positive direction of the Z-axis) from the shell body 111. The bearing 115 may be disposed between the mating opening 111A and the substrate-side opening 111B in the shell body 111.

The lever lock part 116 includes the wall 117 and the groove 118. The lever lock part 116 may be disposed in the shell body 111, for example, in a substrate-side end part 111C. The wall 117 is protruded in the mating direction in the substrate-side end part 111C. The groove 118 is recessed in the substrate-side end part 111C. The groove 118 may be disposed on a side of the claw 112 with respect to the wall 117. The groove 118 may have such a shape that it can hold the gripping part 143.

### <Method>

Next, a method for attaching the connector 200 to the substrate 300 will be described.

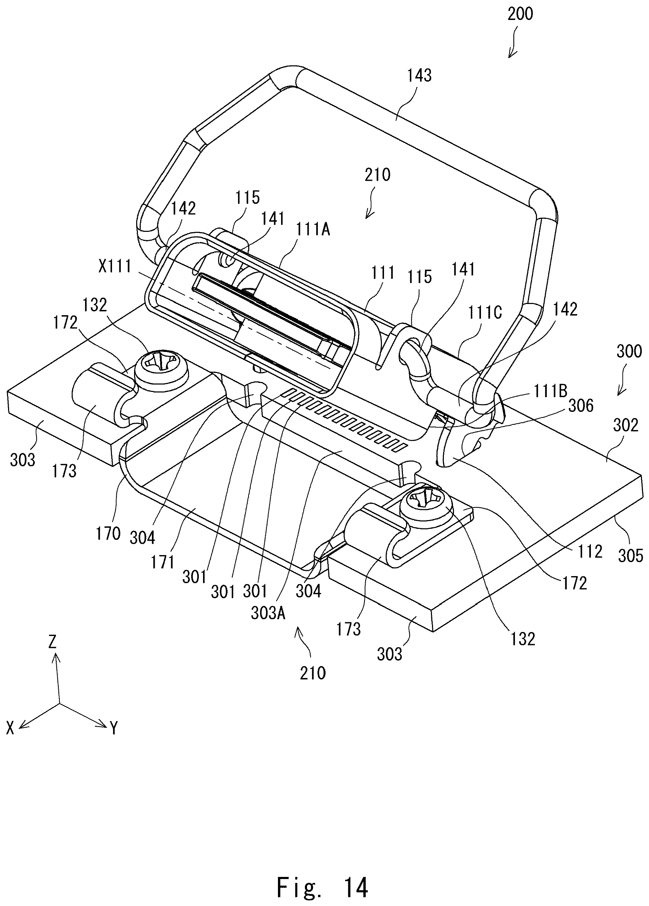

As shown in Fig. 14, like in Step ST11 stated above, the claws 112 of the shell 210 of the connector 200 are inserted into the holes 306 of the substrate 300 (Step ST21). Like in Step ST12 stated above, the position of the connector 200 is inclined in such a way that the axis X111 of the shell body 111 of the connector 200 is along or parallel to the mounting surface 302 of the substrate 300 (Step ST22).

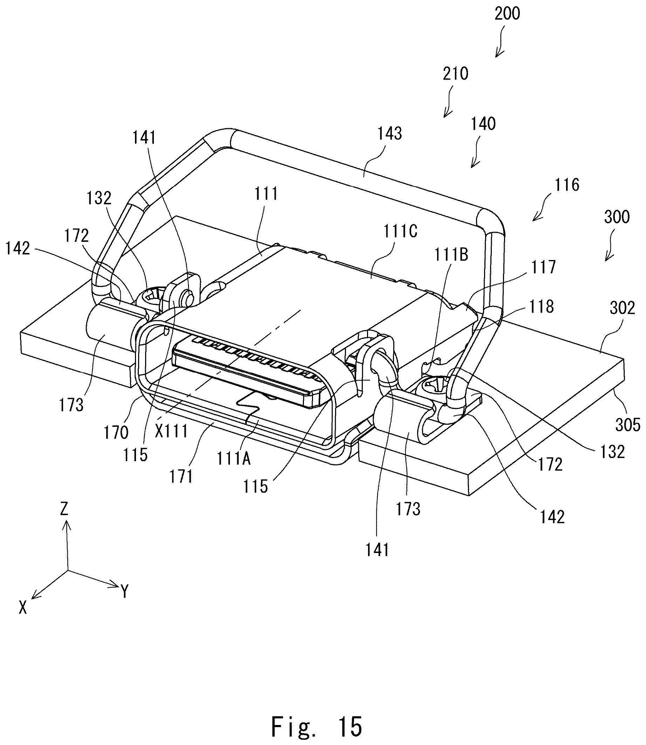

Last, as shown in Figs. 15-20, the lever 140 is rotated toward the substrate-side end part 111C of the shell body 111 about the shaft 141 (Step ST23).

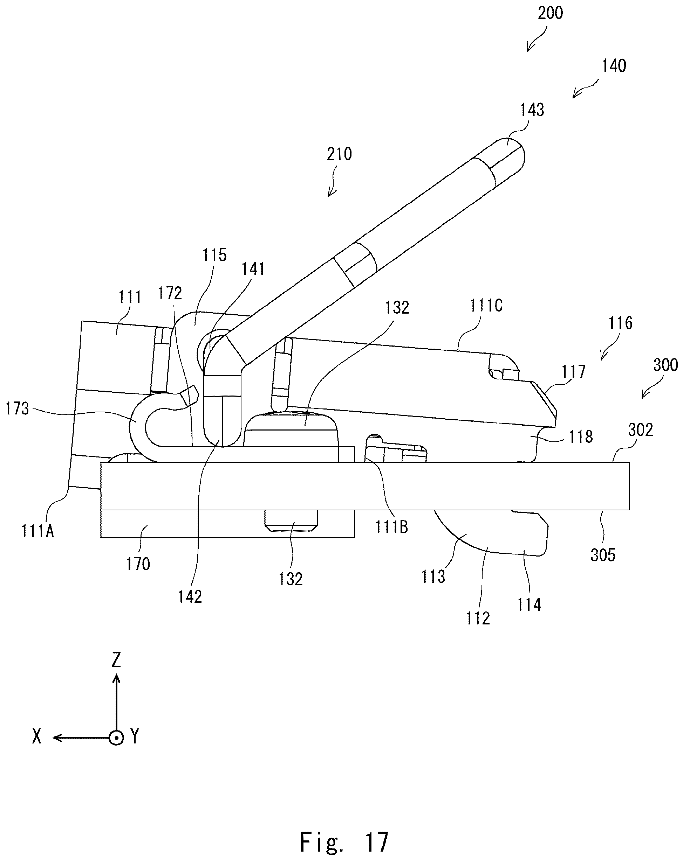

Specifically, the gripping part 143 is gripped by a user, a force is applied by the user, and the lever 140 is rotated. The lever 140 starts rotating toward the substrate-side end part 111C of the shell body 111 about the shaft 141, and the cam part 142 starts rotating toward the cam holding part 173 about the shaft 141. As shown in Figs. 15 and 17, the cam part 142 extends, on the plane on which the lever 140 rotates (in this example, ZX-plane), from the shaft 141 in a direction substantially perpendicular to the mounting surface 302 of the substrate 300, and is pushed against the substrate 300 via the fastening part 172.

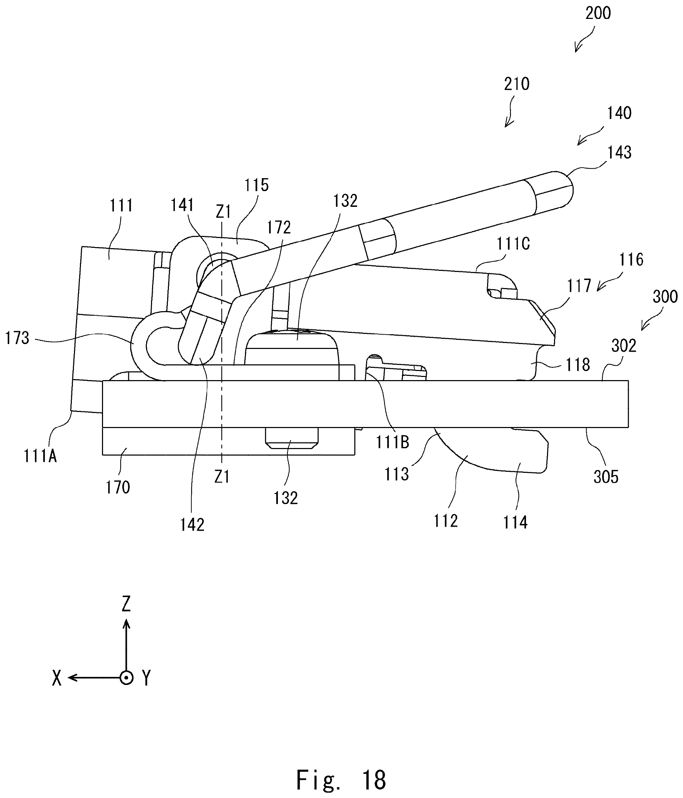

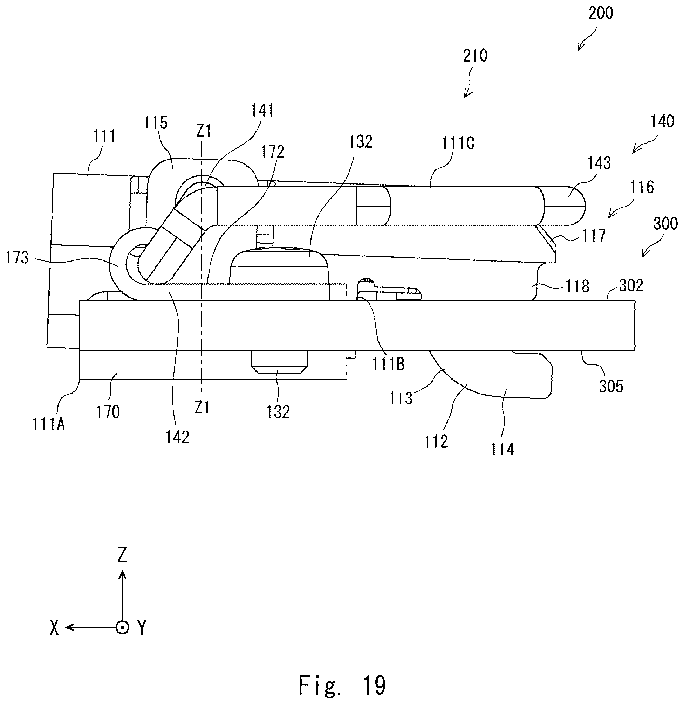

After the rotative movement of the lever 140 is further advanced, as shown in Figs. 18 and 19, the gripping part 143 reaches the wall 117 of the lever lock part 116, and the cam part 142 comes close to the cam holding part 173. On the plane on which the lever 140 rotates, the cam part 142 extends in a direction that is inclined relative to a perpendicular line Z1 of the mounting surface 302 of the substrate 300 that passes through the shaft 141, and moves on the fastening part 172.

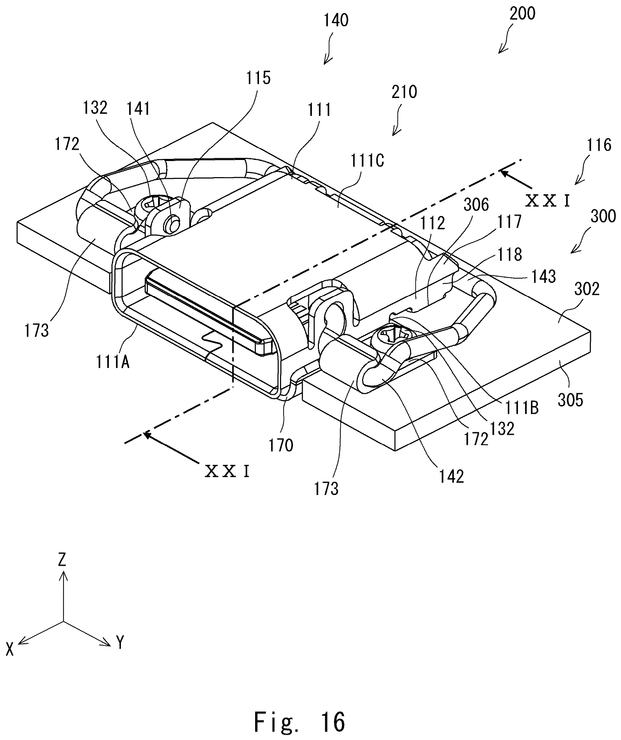

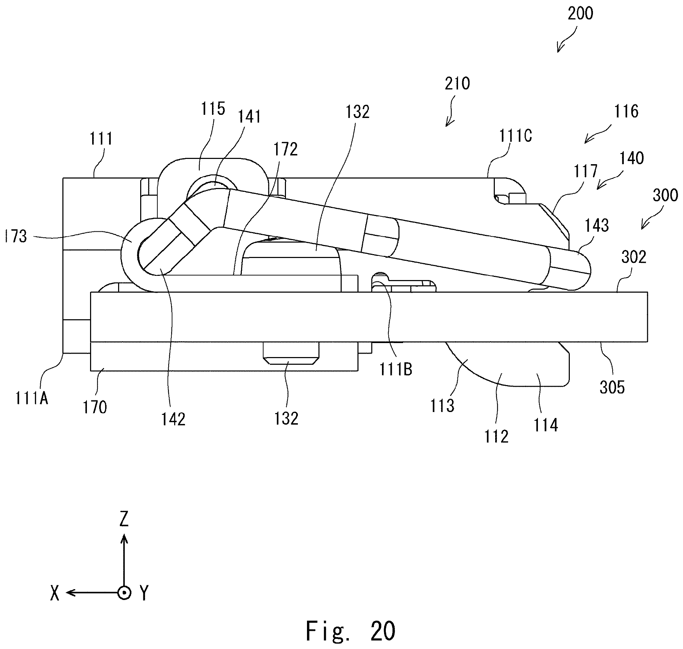

After the rotative movement of the lever 140 is further advanced, as shown in Figs. 16 and 20, the gripping part 143 is elastically deformed, elongated in the mating direction, and passes over the wall 117 of the lever lock part 116. Then, the gripping part 143 is held in the groove 118. That is, the lever lock part 116 locks the lever 140. At the same time, the cam part 142 is pushed against the cam holding part 173 and is held so as to be rotatable. After that, the lever 140 rotates about the cam part 142, and pushes out the shell body 111 of the shell 210 toward the substrate 300 via the shaft 141 and the bearing 115. Thus, the shell 210 is coupled to the substrate 300.

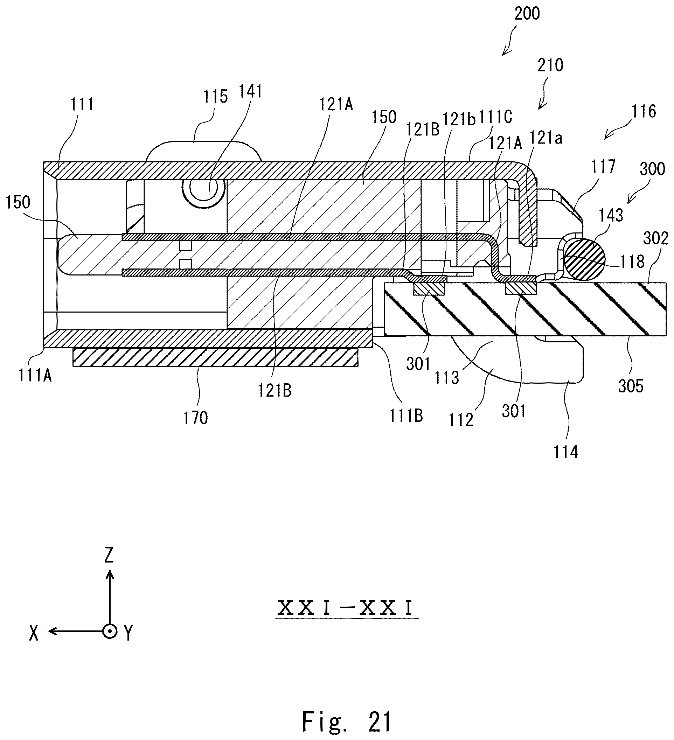

From the above description, the connector 200 is attached to the substrate 300. The plurality of contacts 121A and 121B shown in Fig. 21 are pushed against the plurality of respective pads 301 and are electrically connected thereto. The substrate 300 to which the connector 200 is attached can be used as a connector mounting board.

Regarding the method for detaching the connector 200 from the substrate 300, each step may be performed in an order that is reverse to that in the aforementioned method for attaching the connector 200 to the substrate 300. That is, the lever 140 is rotated about the shaft 141 from the substrate-side end part 111C of the shell body 111 toward the mating opening 111A. The lever 140 locked by the lever lock part 116 is unlocked, and the cam part 142 is made away from the cam holding part 173. Next, the position of the connector 200 is inclined in such a way that the axis X111 of the shell body 111 intersects with the mounting surface 302 of the substrate 300. Lastly, the claws 112 are removed from the holes 306. Thus, the connector 200 can be detached from the substrate 300.

The aforementioned method for attaching the connector 200 to the substrate 300 and the method for detaching the connector 200 from the substrate 300 do not require work that requires much skill or special tools such as soldering and desoldering. That is, these methods can be performed by using widely available tools or user's hands. Therefore, the connector 200 can be easily attached to the substrate 300 and detached from the substrate 300.

Note that the present disclosure is not limited to the aforementioned embodiments, and may be changed as appropriate without departing from the spirit of the present disclosure. For example, while the substrate 300 having the concave surface 303A has been used in the first and second embodiments, a substrate having another shape, such as a substrate having a flat end surface with no concave surface may instead be used.

The first and second embodiments can be combined as desirable by one of ordinary skill in the art.

From the disclosure thus described, it will be obvious that the embodiments of the disclosure may be varied in many ways. Such variations are not to be regarded as a departure from the spirit and scope of the disclosure, and all such modifications as would be obvious to one skilled in the art are intended for inclusion within the scope of the following claims.

## Claims

1. A connector (100) that is capable of being attached to and detached from a substrate (300) including a plurality of pads (301) and is capable of mating with an opponent connector, the connector (100) comprising:
a plurality of contacts (120);
a shell (110) configured to hold the plurality of contacts (120); and
a coupling part (130) configured to removably couple the shell (110) to the substrate (300),
wherein
the shell (110) includes a shell body (111), and a claw (112) protruded from the shell body (111),
the claw (112) includes a claw body (113) and a protrusion (114) that is protruded from the claw body (113),
when the connector (100) is attached to the substrate (300) and is mounted on a mounting surface (302) of the substrate (300) as a result of the claw (112) catching the substrate (300) and the coupling part (130) coupling the shell (110) to the substrate (300),
the contacts (120) include respective contacting parts (121a, 121b) that are pushed against the plurality of respective pads (301),
the claw body (113) penetrates through the substrate (300),
the protrusion (114) extends along a rear surface (305) that faces in a direction opposite to the direction in which the mounting surface (302) faces, and
when the connector (100) is detached from the substrate (300), a distance between the contacting parts (121a, 121b) and the protrusion (114) is smaller than a thickness (TT) of the substrate (300).

2. The connector (100) according to claim 1, wherein
the coupling part (130) further includes a screw-fastened part (130) that extends from the shell body (111), and
the screw-fastened part (130) is fastened to the substrate (300) via a screw (131) and couples the shell (110) to the substrate (300).

3. The connector (100) according to claim 2, wherein
the connector (100) further includes an insulator (150) that insulates the plurality of contacts (120),
the substrate (300) includes a concave part (303A, 304) that is disposed on an end surface (303) of the substrate (300), and
the insulator (150) includes a convex part (151) capable of mating with the concave part (303A, 304).

4. The connector (200) according to claim 1, wherein the coupling part (140, 170) includes:
a lever (140) that is disposed to be rotatable about a shaft (141) in the shell body (210); and
a base plate (170) coupled to the substrate (300),
the lever (140) includes a cam part (142) that extends from the shaft (141), the base plate (170) includes a cam holding part (173) that rotatably holds the cam part (142),
when the lever (140) is rotated about the shaft (141), the cam part (142) is pushed against the cam holding part (173), and the cam holding part (173) rotatably holds the cam part (142),
when the lever (140) continues to be rotated further, the lever (140) is rotated about the cam part (142) and the shaft (141) pushes out the shell body (210) toward the substrate (300), thereby making the shell (210) be coupled to the substrate (300).

5. The connector (200) according to claim 4, wherein
the shell (210) further includes a lever lock part (116) that is disposed in the shell body (210),
the lever (140) includes a gripping part (143) extending in a direction opposite to the direction in which the cam part (142) extends from the shaft (141),
the lever lock part (116) includes a wall (117) that is protruded from the shell body (210) in a mating direction, which is a direction in which the connector (200) mates with the opponent connector, and a groove (118) capable of holding the gripping part (143), and
the lever (140) is rotated about the cam part (142), and the gripping part (143) passes over the wall (117) and is held by the groove (118), whereby the lever lock part (116) locks the lever (140).

6. A connector mounting board comprising:
a substrate (300) including a plurality of pads (301); and
a connector (100) that is attached to the substrate (300), mounted on a mounting surface (302) of the substrate (300), and is capable of mating with an opponent connector,
wherein
the connector (100) comprises:
a plurality of contacts (120);
a shell (110) configured to hold the plurality of contacts (120); and
a coupling part (130) configured to removably couple the shell (110) to the substrate (300),
the shell (110) includes a shell body (111), and a claw (112) protruded from the shell body (111),
the claw (112) includes a claw body (113) and a protrusion (114) that is protruded from the claw body (113),
the claw (112) catches the substrate (300) and the coupling part (130) couples the shell (110) to the substrate (300),
the contacts (120) include respective contacting parts (121a, 121b) that are pushed against the plurality of respective pads (301),
the claw body (113) penetrates through the substrate (300),
the protrusion (114) extends along a rear surface (305) that faces in a direction opposite to the direction in which the mounting surface (302) faces, and
when the connector (100) is detached from the substrate (300), a distance between the contacting parts (121a, 121b) and the protrusion (114) is smaller than a thickness (TT) of the substrate (300).
